# EUROPEAN PATENT SPECIFICATION

(11) **EP 4 088 842 B1**
(45) Date of publication and mention of the grant of the patent: **24.04.2024**
(21) Application number: 21923598.3
(22) Date of filing: 17.02.2021
(51) Int. Cl.: C23C 14/06, C23C 14/00, C23C 14/32, C23C 28/04, C23C 30/00

(54) **CUTTING TOOL**
SCHNEIDWERKZEUG
OUTIL DE COUPE

(43) Date of publication of application: 16.11.2022
(73) Proprietor: Sumitomo Electric Hardmetal Corp., Itami-shi, Hyogo 664-0016 (JP)
(72) Inventor: SUZUKI, Yuta, Itami-shi Hyogo 6640016 (JP); FUKAE, Kosuke, Itami-shi Hyogo 6640016 (JP)
(74) Representative: Boult Wade Tennant LLP
(86) International application number: PCT/JP2021/005903
(87) International publication number: WO 2022/176058

(56) References cited:
- JP-A- 2011 224 717
- JP-A- 2014 083 638
- JP-A- 2019 005 867
- JP-A- 2020 138 301
- US-A1- 2007 259 202
- MORAES V ET AL: "Thermal stability and mechanical properties of Ti-Al-B-N thin films", INTERNATIONAL JOURNAL OF REFRACTORY METALS AND HARD MATERIALS, ELSEVIER, AMSTERDAM, NL, vol. 71, 21 November 2017 (2017-11-21), pages 320-324, XP085328372, ISSN: 0263-4368, DOI: 10.1016/J.IJRMHM.2017.11.027
- PFEILER M ET AL: "Improved oxidation resistance of TiAlN coatings by doping with Si or B", SURFACE AND COATINGS TECHNOLOGY, ELSEVIER, NL, vol. 203, no. 20-21, 15 July 2009 (2009-07-15), pages 3104-3110, XP026142621, ISSN: 0257-8972, DOI: 10.1016/J.SURFCOAT.2009.03.036 [retrieved on 2009-03-27]
- MEI FANGSHENG ET AL: "Greater improvement of carbon and boron co-doping on the mechanical properties, wear resistance and cutting performance of AlTiN coating than that of doping alone", SURFACE AND COATINGS TECHNOLOGY, ELSEVIER, NL, vol. 406, 9 December 2020 (2020-12-09), XP086433711, ISSN: 0257-8972, DOI: 10.1016/J.SURFCOAT.2020.126738 [retrieved on 2020-12-09]
- REBHOLZ ET AL: "Correlation of elastic modulus, hardness and density for sputtered TiAlBN thin films", THIN SOLID FILMS, ELSEVIER, AMSTERDAM, NL, vol. 514, no. 1-2, 30 August 2006 (2006-08-30), pages 81-86, XP005536687, ISSN: 0040-6090, DOI: 10.1016/J.TSF.2006.02.038
- MENDEZ A ET AL: "Effect of Al content on the hardness and thermal stability study of AlTiN and AlTiBN coatings deposited by HiPIMS", SURFACE AND COATINGS TECHNOLOGY, ELSEVIER, NL, vol. 422, 17 July 2021 (2021-07-17), XP086730622, ISSN: 0257-8972, DOI: 10.1016/J.SURFCOAT.2021.127513 [retrieved on 2021-07-17]

## Description

### TECHNICAL FIELD

The present invention relates to a cutting tool.

### BACKGROUND ART

Hitherto, cutting tools having a coating applied onto a base material have been in use. For example, Japanese Patent Laying-Open No. 2011-224715 (PTL 1) discloses a surface-coated cutting tool having a hard coating layer composed of a composite nitride of Al and Ti having a layer thickness of 0.8 to 5.0 µm formed by vapor deposition on the surface of a tool main body composed of a tungsten carbide-based cemented carbide or a titanium carbonitride-based cermet, in which the hard coating layer is configured as an alternating laminate structure of a thin layer A composed of a granular crystal structure of a composite nitride of Al and Ti and a thin layer B composed of a columnar crystal structure, the thin layer A and the thin layer B each have a layer thickness of 0.05 to 2 µm, furthermore, the average crystal grain diameter of granular crystals that constitute the thin layer A is 30 nm or less, and the average crystal grain diameter of columnar crystals that constitute the thin layer B is 50 to 500 nm.

Japanese Patent Laying-Open No. 2017-193004 (PTL 2) discloses a surface-coated cutting tool including a base material and a coating formed on the surface of the base material, in which the coating includes alternating layers, the alternating layers include first layers having a first composition and second layers having a second composition, the alternating layer is configured by laminating one or more first layers and one or more second layers in turn, the first layer and the second layer each have a thickness of 2 nm or more and 100 nm or less, the first composition is represented by TiₐAl_{b}Si_{c}N (0.25 ≤ a ≤ 0.45, 0.55 ≤ b ≤ 0.75, 0 ≤ c ≤ 0.1, and a + b + c = 1), the second composition is represented by Ti_{d}AlₑSi_{f}N (0.35 ≤ d ≤ 0.55, 0.45 ≤ e ≤ 0.65, 0 ≤ f ≤ 0.1, and d + e + f = 1), and the first composition and the second composition satisfy 0.05 ≤ d - a ≤ 0.2 and 0.05 ≤ b - e ≤ 0.2. MORAES V et al, INTERNATIONAL JOURNAL OF REFRACTORY METALS AND HARD MATERIALS, ELSEVIER, AMSTERDAM, NL, (20171121), vol. 71, pages 320 - 324, relates to the thermal stability and mechanical properties of Ti-Al-B-N thin films. PFEILER M et al, SURFACE AND COATINGS TECHNOLOGY, ELSEVIER, NL, vol. 203, no. 20-21, pages 3104 - 3110 relates to improved oxidation resistance of TiAlN coatings by doping with Si or B. MEI FANGSHENG et al, SURFACE AND COATINGS TECHNOLOGY, ELSEVIER, NL, vol. 406, describes greater improvement of carbon and boron co-doping on the mechanical properties, wear resistance and cutting performance of AlTiN coating than that of doping alone. US2007259202A1 relates to a surface-coated cutting tool and method for producing same.

### CITATION LIST

### PATENT LITERATURE

PTL 1: Japanese Patent Laying-Open No. 2011-224715
PTL 2: Japanese Patent Laying-Open No. 2017-193004

### SUMMARY OF INVENTION

A cutting tool according to the present invention is according to claim 1.

### BRIEF DESCRIPTION OF DRAWINGS

Fig. 1 is a perspective view showing an aspect of a cutting tool as an example.
Fig. 2 is a schematic cross-sectional view of a cutting tool in an aspect of the present embodiment.
Fig. 3 is a schematic cross-sectional view for describing a crystal structure of a hard layer according to the present embodiment.
Fig. 4 is an example of a spectrum that is obtained when X-ray diffraction analysis is performed on the hard layer related to the present embodiment.
Fig. 5 is a schematic cross-sectional view of a cutting tool in another aspect of the present embodiment.

### DETAILED DESCRIPTION

### [Problem to be Solved by the Present Invention]

The surface-coated cutting tool described in PTL 1 has a hard coating layer configured as described above, which improves the wear resistance and thereby makes extension of the service life of the cutting tool expected. The surface-coated cutting tool described in PTL 2 has a coating configured as described above, which suppresses interlayer peeling and crack propagation and thereby makes extension of the service life of the cutting tool expected. However, in recent years, the speed and efficiency of cutting process have been progressed leading in an increase of a load applied to a cutting tool, so that the service life of cutting tools was likely to become short. Therefore, there has been a demand for additional improvement in the mechanical characteristics (for example, wear resistance, defect resistance and heat resistance) of coatings for cutting tools.

The present invention has been made in consideration of the above-described circumstances, and an objective of the present invention is to provide a cutting tool having excellent wear resistance.

### [Advantageous Effect of the Present Invention]

According to the above, a cutting tool having excellent wear resistance can be provided.

### [Description of Embodiments]

First, embodiments of the present invention will be listed and described.

A cutting tool according to the present invention is according to claim 1.

In the hard layer of the cutting tool, the ratio I₍₂₀₀₎/I₍₀₀₂₎ and the full width at half maximum of the X-ray diffraction peak of the (002) plane are in the above-described ranges, whereby the cutting tool becomes excellent in terms of wear resistance. In addition, the atomic ratio of the aluminum element is in the above-described range, whereby the cutting tool becomes excellent in terms of heat resistance. That is, the cutting tool has the above-described configuration and is thereby enabled to have excellent wear resistance in high-temperature environments. In other words, the cutting tool has a long service life even when used in the processing of hard-to-cut materials where the cutting temperature significantly increases as well as in the processing of ordinary steel. Here, "wear resistance" means the resistance of the cutting tool to wear during cutting processes. "Heat resistance" means the resistance of the cutting tool to wear, deformation and the like in high-temperature environments.

The hard layer preferably has hardness H of 30 GPa or more at room temperature. Such a regulation makes it possible for the cutting tool to have superior wear resistance.

A ratio H/E of the hardness H of the hard layer to Young's modulus E of the hard layer at room temperature is preferably 0.07 or more. Such a regulation makes it possible for the cutting tool to have not only excellent wear resistance but also excellent defect resistance. Here, "defect resistance" means the resistance of the cutting tool to defects during cutting processes.

The hard layer preferably has a thickness of 1 µm or more and 20 µm or less. Such a regulation makes it possible for the cutting tool to have superior wear resistance.

### [Details of Embodiments of the Present Invention]

Hereinafter, an embodiment according to the present invention (hereinafter, referred to as "present embodiment") will be described. However, the present invention is not limited thereto. A numerical expression in the form of "A to Z" herein means the upper limit and lower limit of a range (that is, A or more and Z or less), and, when a unit is not put after A but put after Z only, the unit of A and the unit of Z are the same. Furthermore, when a compound is herein represented by a chemical formula where the compositional proportions of constituting elements are not particularly limited like, for example, "TiN," the chemical formula is assumed to include all conventionally-known compositional proportions (element proportions). At this time, the chemical formula includes not only stoichiometric compositions but also non-stoichiometric compositions. For example, the chemical formula "TiN" includes not only a stoichiometric composition "Ti₁N₁" but also a non-stoichiometric composition like, for example, "Ti₁N_{0.8}." The same is applied for the expression of compounds other than "TiN."

### < < Cutting Tool>>

The cutting tool according to the present embodiment is according to claim 1.

Examples of the cutting tool according to the present embodiment include a drill, an end mill, a blade edge-replaceable cutting tip for a drill, a blade edge-replaceable cutting tip for an end mill, a blade edge-replaceable cutting tip for milling, a blade edge-replaceable cutting tip for turning, a metal saw, a gear cutting tool, a reamer, and a tap.

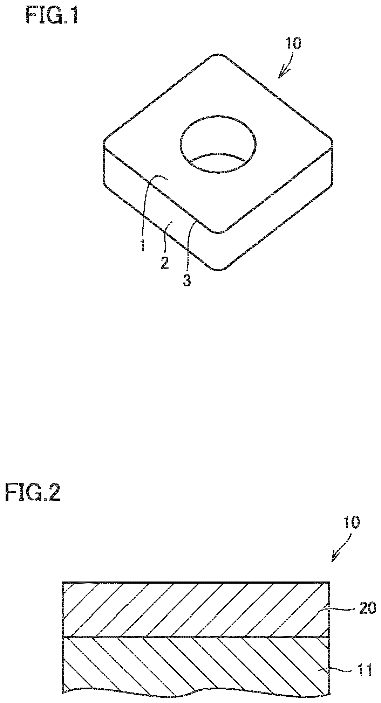

Fig. 1 is a perspective view showing an aspect of a cutting tool as an example. A cutting tool having such a shape is used as, for example, a blade edge-replaceable cutting tip. The above-described cutting tool 10 has a rake face 1, a flank face 2 and a blade edge ridge portion 3 where rake face 1 and flank face 2 intersect with each other. That is, rake face 1 and flank face 2 are surfaces connected to each other across blade edge ridge portion 3. Blade edge ridge portion 3 constitutes a cutting blade edge tip portion of cutting tool 10. Such a shape of cutting tool 10 can also be regarded as the shape of the base material of the cutting tool. That is, the base material has a rake face, a flank face and a blade edge ridge portion that connects the rake face and the flank face.

### <Base Material>

As the base material of the present embodiment, any base material can be used as long as the base material is conventionally known as this kind of base material. For example, the base material preferably contains one selected from the group consisting of a cemented carbide (for example, tungsten carbide (WC)-based cemented carbide, cemented carbide containing Co in addition to WC, and cemented carbide to which, in addition to WC, a carbonitride of Cr, Ti, Ta, Nb or the like is added), a cermet (cermet containing TiC, TiN, TiCN or the like as the main component), high-speed steel, ceramic (titanium carbide, silicon carbide, silicon nitride, aluminum nitride, aluminum oxide or the like), a cubic boron nitride sintered body (cBN sintered body) and a diamond sintered body.

Among a variety of these base materials, in particular, a cemented carbide (particularly WC-based cemented carbide) and a cermet (particularly TiCN-based cermet) are preferably selected. The reason therefor is that these base materials are particularly excellent in terms of the balance between hardness and strength at high temperatures and have excellent characteristics as base materials for cutting tools in the above-described uses.

When a cemented carbide is used as the base material, such a cemented carbide exhibits the effect of the present embodiment even when containing free carbon or an abnormal phase called an η phase in the structure. The base material that is used in the present embodiment may have a modified surface. For example, the base material may have a β-free layer formed on the surface in the case of being a cemented carbide or may have a surface hardened layer formed in the case of being a cBN sintered body, and the effect of the present embodiment is exhibited even when the surface is modified as described above.

When the cutting tool is a blade edge-replaceable cutting tip (a blade edge-replaceable cutting tip for turning, a blade edge-replaceable cutting tip for milling or the like), the base material may or may not have a tip breaker. The shape of the ridge portion of the blade edge may be any shape of a sharp edge (a ridge where the rake face and the flank face intersect with each other), horning (a shape of the sharp edge provided with an R), a negative land (a chamfered shape) and a shape where horning and a negative land are combined.

### <Coating>

The coating according to the present embodiment is provided on the base material. "Coating" is a member that coats at least part of the base material (for example, part of the rake face) and thereby has an action of improving a variety of characteristics such as heat resistance, defect resistance and wear resistance of the cutting tool. The coating preferably coats the entire surface of the base material. However, even when part of the base material is not coated with the coating or the configuration of the coating partially differs, such a configuration does not deviate from the scope of the present embodiment. The coating includes a hard layer.

The thickness of the coating is preferably 1 µm or more and 20 µm or less, more preferably 1.5 µm or more and 12 µm or less and still more preferably 2 µm or more and 8 µm or less. Here, the thickness of the coating means the sum of the thicknesses of individual layers that constitute the coating. Examples of "layers that constitute the coating" include the hard layer and other layers described below such as an underlayer, an interlayer and a surface layer. The thickness of the coating can be obtained by, for example, measuring 10 arbitrary points in a cross-sectional sample parallel to the normal direction to the surface of the base material using a transmission electron microscope (TEM) and calculating the average value of the thicknesses at the 10 measured points. The measurement magnification at this time is, for example, 10000 times. Examples of the cross-sectional sample include a sample obtained by slicing a cross section of the cutting tool with an ion slicer device. The same is also applied when the thickness of each of the hard layer, the underlayer, the interlayer, the surface layer and the like is measured. Examples of the transmission electron microscope include JEM-2100F (trade name) manufactured by JEOL Ltd.

### (Hard Layer)

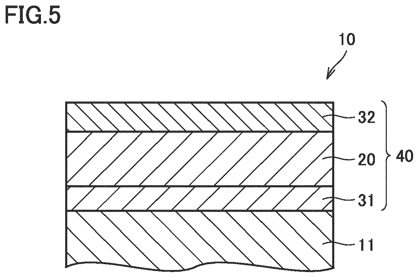

A hard layer 20 according to the present embodiment is provided on a base material 11. Hard layer 20 may be provided directly on base material 11 (Fig. 2) or may be provided on base material 11 through another layer such as an underlayer 31 (Fig. 5) as long as the effect exhibited by the cutting tool according to the present embodiment is maintained. As long as the effect exhibited by the cutting tool is maintained, another layer such as a surface layer 32 may be provided on hard layer 20 (Fig. 5). In addition, hard layer 20 may be provided on the surface of the above-described coating 40.

In one aspect of the present embodiment, a plurality of the hard layers may be provided as long as the effect exhibited by the cutting tool is maintained. For example, when the coating includes a first hard layer and a second hard layer, the coating may further include an interlayer that is provided between the first hard layer and the second hard layer.

The hard layer preferably coats the flank face of the base material. The hard layer preferably coats the rake face of the base material. The hard layer more preferably coats the entire surface of the base material. However, even when part of the base material is not coated with the hard layer, such a configuration does not deviate from the scope of the present embodiment.

The thickness of the hard layer is preferably 1 µm or more and 20 µm or less, more preferably 1.5 µm or more and 12 µm or less and still more preferably 2 µm or more and 8 µm or less. In such a case, it becomes possible for the cutting tool to have superior wear resistance. The thickness can be measured by, for example, observing the above-described cross section of the cutting tool using a transmission electron microscope at a magnification of 10000 times.

### (X-ray Diffraction Analysis in Hard Layer)

The ratio I₍₂₀₀₎/I₍₀₀₂₎ of the intensity I₍₂₀₀₎ of an X-ray diffraction peak of a (200) plane to the intensity I₍₀₀₂₎ of an X-ray diffraction peak of a (002) plane in the hard layer is 2 or more and 10 or less, and
the full width at half maximum of the X-ray diffraction peak of the (002) plane is 2 degrees or more and 8 degrees or less. Here, "the intensity I₍₂₀₀₎ of an X-ray diffraction peak of a (200) plane" means the diffraction intensity (peak height) of the highest peak of X-ray diffraction peaks derived from the (200) plane. The same is also applied for "the intensity I₍₀₀₂₎ of an X-ray diffraction peak of a (002) plane."

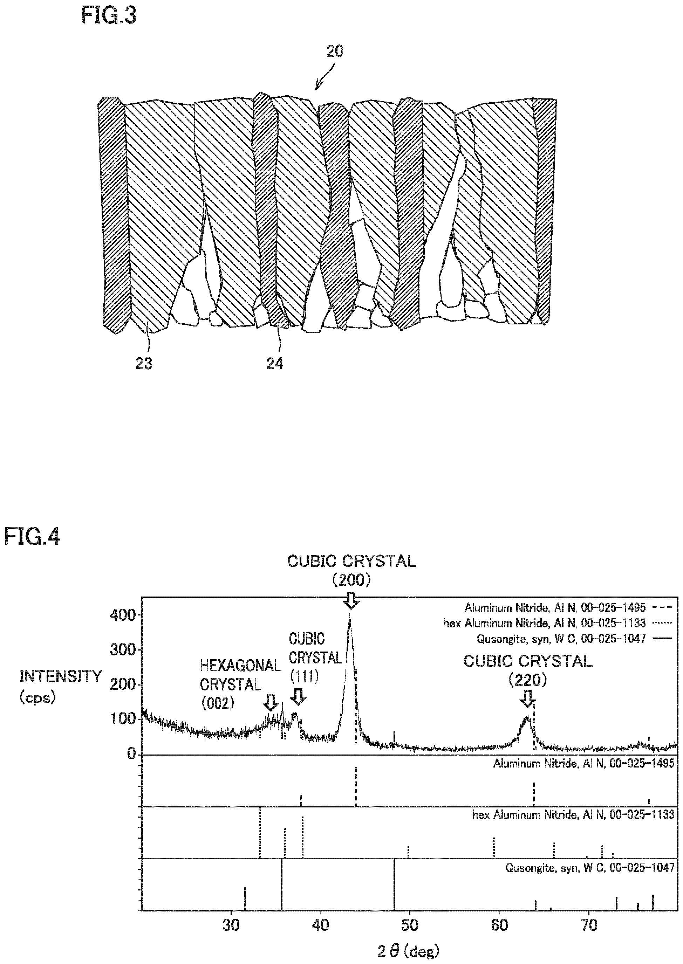

Specifically, X-ray diffraction measurement (XRD measurement) by a θ/2θ method is performed on each of 3 arbitrary points in the hard layer under conditions described in examples described below, the X-ray diffraction intensity of a predetermined crystal plane is obtained, and the average value of the obtained X-ray diffraction intensities at the 3 points is regarded as the X-ray diffraction intensity of the predetermined crystal plane. At this time, the X-ray diffraction intensity of the (200) plane corresponds to an X-ray diffraction intensity at 2θ = near 43° to 44°, and the X-ray diffraction intensity of the (002) plane corresponds to an X-ray diffraction intensity at 2θ = near 30° to 40° (for example, refer to Fig. 4). In Fig. 4, the vertical axis indicates the diffraction intensities of an X ray, and the horizontal axis indicates the values of 2θ. Examples of a device that is used for the X-ray diffraction measurement include "SmartLab" (trade name) manufactured by Rigaku Corporation and "X'pert" (trade name) manufactured by Malvern PANalytical Ltd.

The X-ray diffraction intensity of the (200) plane is derived from cubic crystals in the hard layer. The intensity I₍₀₀₂₎ of the X-ray diffraction peak of the (002) plane is derived from hexagonal crystals in the hard layer. Therefore, the presence or absence of cubic and hexagonal crystals in the hard layer can be determined from the presence or absence of these peaks. In addition, the ratio I₍₂₀₀₎/I₍₀₀₂₎ being 2 or more and 10 or less means that mixed crystals of cubic columnar crystals 23 and hexagonal columnar crystals 24 are formed in the hard layer (Fig. 3).

The upper limit of the ratio I₍₂₀₀₎/I₍₀₀₂₎ may be, for example, less than 10 or 5 or less.

The upper limit of the full width at half maximum of the X-ray diffraction peak of the (002) plane may be 6 degrees or less or 4 degrees or less.

### (Mechanical Characteristics in Hard Layer)

The hardness H of the hard layer at room temperature in the present embodiment is preferably 30 GPa or more, more preferably 30 GPa or more and 50 GPa or less and still more preferably 35 GPa or more and 45 GPa or less.

The Young's modulus E of the hard layer at room temperature in the present embodiment is preferably 700 GPa or less, more preferably 400 GPa or more and 700 GPa or less and still more preferably 400 GPa or more and 550 GPa or less.

In addition, the ratio H/E of the hardness H of the hard layer to the Young's modulus E of the hard layer at room temperature is preferably 0.07 or more, more preferably 0.07 or more and 0.12 or less and still more preferably 0.08 or more and 0.11 or less.

The hardness H and the Young's modulus E can be obtained by a nanoindentation method according to the standard procedure specified in "ISO 14577-1: 2015 Metallic materials - Instrumented indentation test for hardness and materials parameters -." "Room temperature" in the present embodiment refers to 25°C. From the viewpoint of accurately obtaining the hardness H and the Young's modulus E, the indentation depth of the indenter is set so as not to exceed 1/10 of the thickness of the hard layer in the indentation direction of the indenter. The indentation load of the indenter is set to 1 g. The above-described cross-sectional sample may be used as a sample as long as a cross-sectional area of the hard layer that is 10 times wider than the area of the indenter can be secured. In addition, a sample having a cross section inclined with respect to the normal direction to the surface of the base material such that a cross-sectional area of the hard layer that is sufficiently wide compared with the indenter can be secured may also be used. Such measurement is performed on at least 10 cross-sectional samples, and the average values of the hardnesses and the Young's moduli that are obtained from the respective samples are regarded as the hardness H and the Young's modulus E of the hard layer. Data that are considered as abnormal values at first glance are excluded. Examples of a device for performing the nanoindentation method include ENT-1100a manufactured by Elionix Inc.

The hard layer is composed of a compound represented by TiₐAl_{b}B_{c}N. Here, the concept of "being composed of a compound represented by TiₐAl_{b}B_{c}N" includes an aspect where the hard layer is composed of the compound represented by TiₐAl_{b}B_{c}N alone and an aspect where the hard layer is composed of the compound represented by TiₐAl_{b}B_{c}N and an inevitable impurity. Examples of the inevitable impurity include carbon (C) and oxygen (O). The composition of the hard layer can be obtained by analyzing the elements in the entire hard layer by the attendant energy-dispersive X-ray spectroscopy equipped with TEM (TEM-EDX) performed on the above-described cross-sectional sample. The observation magnification at this time is, for example, 20000 times.

The atomic ratio a of a titanium element in the TiₐAl_{b}B_{c}N is 0.25 or more and less than 0.55, preferably 0.25 or more and 0.40 or less and more preferably 0.25 or more and 0.35 or less. When the atomic ratio a is set in the above-described range, the hard layer has appropriate hardness.

The atomic ratio b of an aluminum element in the TiₐAl_{b}B_{c}N is 0.45 or more and less than 0.75, preferably 0.55 or more and less than 0.75 and more preferably 0.65 or more and less than 0.75. When the atomic ratio b is set in the above-described range, the hard layer has excellent heat resistance.

The atomic ratio c of a boron element in the TiₐAl_{b}B_{c}N is 0.01 or more and 0.09 or less and preferably 0.02 or more and 0.08 or less. When the atomic ratio c is set in the above-described range, the hard layer has appropriate hardness. The sum of the atomic ratio a, the atomic ratio b and the atomic ratio c is 1.

### (Other Layers)

The coating may further include other layers as long as the effect of the present embodiment is not impaired. Examples of the other layers include an underlayer that is provided between the base material and the hard layer, and a surface layer that is provided on the hard layer. In addition, examples thereof include an interlayer that is provided between a first hard layer and a second hard layer when the coating includes the first hard layer and the second hard layer.

The underlayer may be a layer composed of, for example, a compound represented by AlCrN. The surface layer may be a layer composed of, for example, a compound represented by TiN. The interlayer may be a layer composed of, for example, a compound represented by TiAlN. The compositions of the other layers can be obtained by analyzing the elements in all of the other layers by the attendant energy-dispersive X-ray spectroscopy equipped with TEM (TEM-EDX) performed on the above-described cross-sectional sample. The observation magnification at this time is, for example, 20000 times.

The thickness of each of the other layers is not particularly limited as long as the effect of the present embodiment is not impaired and is, for example, 0.1 µm or more and 2 µm or less. The thickness can be measured by, for example, observing the above-described cross section of the cutting tool using a transmission electron microscope at a magnification of 10000 times.

### <<Method for Manufacturing Cutting Tool>>

A method for manufacturing the cutting tool according to the present embodiment includes
a step of preparing the base material (hereinafter, referred to as "first step" in some cases) and
a step of forming the hard layer on the base material using a physical vapor deposition method (hereinafter, referred to as "second step" in some cases).

The physical vapor deposition method refers to a vapor deposition method in which a raw material (also referred to as "evaporation source" or "target") is gasified using a physical action and the gasified raw material is attached onto a base material or the like. Examples of the physical vapor deposition method include a sputtering method and an arc ion plating method. In particular, as the physical vapor deposition method that is used in the present embodiment, an arc ion plating method is preferably used.

In the arc ion plating method, a base material is installed in a device, a target is installed as a cathode, and then a high current is applied to this target to cause an arc discharge. Therefore, atoms that constitute the target are evaporated, ionized and caused to sediment on the base material to which a negative bias voltage has been applied to form a coating.

### <First Step: Step of Preparing Base Material>

In the first step, a base material is prepared. For example, a cemented carbide base material or a cubic boron nitride sintered body is prepared as a base material. As the cemented carbide base material and the cubic boron nitride sintered body, commercially available base materials may be used or the cemented carbide base material and the cubic boron nitride sintered body may be manufactured by an ordinary powder metallurgical method. For example, when a cemented carbide is manufactured by an ordinary powder metallurgical method, first, a WC powder, a Co powder and the like are mixed with a ball mill or the like to obtain a powder mixture. The powder mixture is dried and then formed into a predetermined shape to obtain a formed article. Furthermore, the formed article is sintered, thereby obtaining a WC-Co-based cemented carbide (sintered body). Next, a predetermined blade edge process such as a horning treatment is performed on the sintered body, whereby a base material composed of the WC-Co-based cemented carbide can be manufactured. In the first step, any conventionally known base material that is not the above-described base material can be prepared as this kind of base material.

### <Second Step: Step of Forming Hard Layer>

In the second step, the hard layer is formed using a physical vapor deposition method. As this method, a variety of methods can be used depending on the composition of a hard layer that is intended to be formed. Examples of the method include a method in which an alloy target in which the grain diameters of titanium (Ti), aluminum (Al), boron (B) and the like are changed respectively is used, a method in which a plurality of targets having mutually different compositions is used, a method in which a bias voltage that is applied when forming a film is a pulse voltage, a method in which the gas flow rate is changed when forming a film, and a method in which the rotation speed of a base material holder that holds the base material in a film-forming device is adjusted.

For example, the second step can be performed as described below. First, a tip having an arbitrary shape is mounted in a chamber of a film-forming device as the base material. For example, the base material is attached to the outer surface of a base material holder on a rotary table provided so as to be rotatable in the center in the chamber of the film-forming device. Next, evaporation sources for forming the hard layer are disposed opposite to each other across the base material holder. A bias power supply is attached to the base material holder. Arc power supplies are attached to the evaporation sources for forming the hard layer. A nitrogen gas or the like is introduced as a reaction gas in a state where the base material is rotated in the center in the chamber. Furthermore, 80 to 200 A arc currents are alternately supplied to the evaporation sources for forming the hard layer while the base material is maintained at a temperature of 400 to 800°C, the reaction gas pressure is maintained at 1 to 10 Pa (the partial pressure of the nitrogen gas is 1 to 10 Pa) and the voltage of the bias power supply is maintained in a range of 20 to 50 V (direct current power supply). Therefore, metal ions are generated from the evaporation sources for forming the hard layer, and a hard layer is caused to sediment on the base material. The supply of the arc current is stopped when a predetermined time has elapsed to form a hard layer on the surface of the base material. At this time, the thickness of the hard layer is adjusted to be in a predetermined range by adjusting the film-forming time. In the second step, a hard layer may be formed not only in a portion that is to be involved in a cutting process (for example, a rake face near a cutting blade) but also on the surface of the base material other than the portion that is to be involved in the cutting process. As described above, when the nitrogen gas partial pressure is set to be high and the bias voltage is set to be low compared with those in the related art, it is possible to control crystal growth during film formation and achieve the formation of mixed crystals.

Conventionally, it is known that, in a layer composed of a compound represented by TiAlN (TiAlN layer), cubic crystals are dominant and hardness is excellent. On the other hand, it is known that, when boron is added as a raw material when forming this TiAlN layer, hexagonal crystals are likely to be formed, and hardness decreases. Therefore, normally, it has not been considered to use, in addition to titanium and aluminum, boron as a raw material when forming the TiAlN layer. The present inventors formed a hard layer by adding, in addition to titanium and aluminum, a small amount of boron as a raw material without being tied to such a common sense and found for the first time that, contrary to expectation, a cutting tool having excellent wear resistance can be obtained.

In one aspect of the present embodiment, it is preferable that 80 to 120 A arc currents are alternately supplied to the evaporation sources for forming the hard layer while the base material is maintained at a temperature of 500 to 600°C, the reaction gas pressure is maintained at 5 to 10 Pa (the partial pressure of the nitrogen gas is 5 to 10 Pa) and the voltage of the bias power supply is maintained in a range of 30 to 50 V (direct current power supply). In such a case, it becomes possible to set the hardness H and Young's modulus E of the hard layer in the above-described ranges. Therefore, the toughness and the hardness in the hard layer improve.

### (Raw Material of Hard Layer)

In the second step, the raw materials of the hard layer include titanium, aluminum and boron, and examples thereof include titanium boride, metallic aluminum and aluminum titanium boride. The formulation of the raw materials of the hard layer can be adjusted as appropriate depending on the composition of a target hard layer. The raw materials of the hard layer may have a powder shape or a planar shape.

In the present embodiment, the above-described reaction gas is set as appropriate depending on the composition of the hard layer. Examples of the reaction gas include a gas mixture of a nitrogen gas and an argon gas, and a nitrogen gas.

### <Other Steps>

In the manufacturing method according to the present embodiment, in addition to the above-described steps, a step of performing an ion bombardment treatment on the surface of the base material, a step of forming an underlayer between the base material and the hard layer, a step of forming a surface layer on the hard layer, a step of forming an interlayer between a first hard layer and a second hard layer, a step of performing a surface treatment and the like may be performed as appropriate between the first step and the second step.

In the case of forming the above-described other layers such as the underlayer, the interlayer and the surface layer, the other layers may be formed by a conventional method.

### Examples

Hereinafter, the present invention will be described in detail using Examples, but the present invention is not limited thereto.

### <<Production of Cutting Tool>>

### <Preparation of Base Material>

First, as base materials for a coating to be formed, a blade edge-replaceable cutting tip P for cutting by rolling (JIS P30-equivalent cemented carbide, SEMT13T3AGSN) and a blade edge-replaceable cutting tip K for cutting by rolling (JIS K30-equivalent cemented carbide, SEMT13T3AGSN) were prepared (first step).

### <Ion Bombardment Treatment>

Prior to the production of coatings described below, an ion bombardment treatment was performed on the surfaces of the base materials by the following procedure. First, the base material was set in an arc ion plating device. Next, the ion bombardment treatment was performed under the following conditions.
Gas composition: Ar (100%)
Gas pressure: 0.5 Pa
Bias voltage: 600 V (direct current power supply)
Treatment time: 60 minutes

### <Production of Coating>

The coating was produced by forming hard layers shown in Table 2 on the surface of the base materials on which the ion bombardment treatment was performed. Hereinafter, a method for producing the hard layer will be described.

### (Production of Hard Layer)

For Specimens 1 to 12 and Specimens 102 to 107, a nitrogen gas was introduced as a reaction gas in a state where the base materials (blade edge-replaceable cutting tip P for cutting by rolling and blade edge-replaceable cutting tip K for cutting by rolling) were rotated in the center in a chamber. Furthermore, 120 A arc currents were supplied to evaporation sources for forming the hard layer while the base materials were maintained at a temperature of 550°C, the reaction gas pressure was maintained at 8 Pa (the partial pressure of the nitrogen gas: 8 Pa) and the voltage of a bias power supply was maintained at 30 V. Therefore, metal ions were generated from the evaporation sources for forming the hard layer, and the supply of the arc currents was stopped when a predetermined time had elapsed to form hard layers having a composition shown in Table 2 on the surfaces of the base materials (second step). Here, as the evaporation sources for forming the hard layer, evaporation sources having a raw material composition shown in Table 1 were used. At this time, the hard layers were produced while adjusting the film-forming time so as to obtain thicknesses shown in Table 2. The compositions of the hard layers in Table 2 were obtained by analyzing the elements in the entire hard layers by the attendant energy-dispersive X-ray spectroscopy equipped with TEM (TEM-EDX) performed on cross-sectional samples as described above. The observation magnification at this time was 20000 times.

Cutting tools of Specimens 1 to 12 and Specimens 101 to 107 were produced by the above-described steps.

**[Table 1]**

| Specimen | Raw material composition of evaporation source for forming hard layer | | |
|---|---|---|---|
| | Ti | Al | B |
| 1 | 0.30 | 0.63 | 0.07 |
| 2 | 0.25 | 0.70 | 0.05 |
| 3 | 0.50 | 0.45 | 0.05 |
| 4 | 0.40 | 0.50 | 0.10 |
| 5 | 0.30 | 0.60 | 0.10 |
| 6 | 0.30 | 0.63 | 0.07 |
| 7 | 0.45 | 0.50 | 0.05 |
| 8 | 0.30 | 0.60 | 0.10 |
| 9 | 0.30 | 0.63 | 0.07 |
| 10 | 0.30 | 0.60 | 0.10 |
| 11 | 0.45 | 0.45 | 0.10 |
| 12 | 0.50 | 0.45 | 0.05 |
| 101 | 0.20 | 0.75 | 0.05 |
| 102 | 0.50 | 0.45 | 0.05 |
| 103 | 0.50 | 0.45 | 0.05 |
| 104 | 0.35 | 0.65 | 0 |
| 105 | 0.55 | 0.45 | 0 |
| 106 | 0.25 | 0.60 | 0.15 |
| 107 | 0.30 | 0.60 | 0.10 |

**[Table 2]**

| Specimen | Hard layer (TiₐAl_{b}B_{c}N) | | | | |
|---|---|---|---|---|---|
| | Composition of metal components | | | Layer structure | Thickness (µm) |
| | Ti (a) | Al (b) | B (c) | | |
| 1 | 0.34 | 0.61 | 0.05 | Single layer | 5.0 |
| 2 | 0.26 | 0.73 | 0.01 | Single layer | 12.0 |
| 3 | 0.53 | 0.46 | 0.01 | Single layer | 8.0 |
| 4 | 0.40 | 0.51 | 0.09 | Single layer | 5.0 |
| 5 | 0.37 | 0.57 | 0.06 | Single layer | 3.0 |
| 6 | 0.34 | 0.62 | 0.04 | Single layer | 0.9 |
| 7 | 0.39 | 0.58 | 0.03 | Single layer | 20.8 |
| 8 | 0.39 | 0.56 | 0.05 | Single layer | 7.0 |
| 9 | 0.30 | 0.65 | 0.05 | Single layer | 0.8 |
| 10 | 0.33 | 0.58 | 0.09 | Single layer | 21.4 |
| 11 | 0.46 | 0.47 | 0.07 | Single layer | 13.0 |
| 12 | 0.52 | 0.47 | 0.01 | Single layer | 0.9 |
| 101 | 0.22 | 0.76 | 0.02 | Single layer | 15.0 |
| 102 | 0.66 | 0.30 | 0.04 | Single layer | 2.0 |
| 103 | 0.56 | 0.42 | 0.02 | Single layer | 6.0 |
| 104 | 0.38 | 0.62 | - | Single layer | 11.0 |
| 105 | 0.54 | 0.46 | - | Single layer | 19.0 |
| 106 | 0.35 | 0.54 | 0.11 | Single layer | 7.0 |
| 107 | 0.29 | 0.63 | 0.08 | Single layer | 9.0 |

### <<Characteristic Evaluation of Cutting Tool>>

Each characteristic of the cutting tool was evaluated as described below using the cutting tools of Specimens 1 to 12 and Specimens 101 to 107 produced as described above. Here, the cutting tools of Specimens 1 to 12 correspond to Examples, and the cutting tools of Specimens 101 to 107 correspond to Comparative Examples.

### <Measurement of Thickness of Coating (Thickness of Hard Layer)>

The thickness of the coating (that is, the thickness of the hard layer) was obtained by measuring 10 arbitrary points in the cross-sectional sample parallel to the normal direction to the surface of the base material using a transmission electron microscope (TEM) (manufactured by JEOL Ltd., trade name: JEM-2100F) and calculating the average value of the thicknesses at the 10 measured points. The results are shown in Table 2.

### <X-ray Diffraction Analysis of Hard Layer>

The hard layers were analyzed by an X-ray diffraction analysis method (XDR analysis method) to obtain the X-ray diffraction intensities I₍₂₀₀₎ and I₍₀₀₂₎ of a (200) plane and a (002) plane, respectively. The conditions for the X-ray diffraction analysis are as shown below. The obtained I₍₂₀₀₎/I₍₀₀₂₎ and peak full width at half maximums of I₍₀₀₂₎ are shown in Table 3.
Conditions for X-ray diffraction analysis
Scanning axis: 2θ-θ
X-ray source: Cu-Kα ray (1.541862 Å)
Detector: 0-dimension detector (scintillation counter)
Tube voltage: 45 kV
Tube current: 40 mA
Incident optical system: A mirror was used
Light reception optical system: Analyzer crystals (PW3098/27) were used Step: 0.03°
Integration time: 2 seconds
Scan range (2θ): 20° to 80°

In addition, the presence or absence of cubic crystals and hexagonal crystals in the hard layers was determined based on the results of the above-described X-ray diffraction analysis. The results are shown in Table 3.

### <Analysis of Mechanical Characteristics of Hard Layer (Analysis of Hardness and Young's Modulus)>

The hardness H and the Young's modulus E of the hard layer in each cutting tool were measured by a nanoindentation method according to the standard procedure specified in "ISO 14577-1: 2015 Metallic materials - Instrumented indentation test for hardness and materials parameters -." Here, the indentation depth of an intender was set to 100 nm. The indentation load of the indenter was set to 1 g. The measurement temperature was set to room temperature (25°C). In addition, a cross-sectional sample finished to a mirror-like surface such that a cross-sectional area of the hard layer that was 10 times wider than the area of the indenter could be secured was used as a sample. As a measuring instrument, ENT-1100a (trade name) manufactured by Elionix Inc. was used. The measurement was performed on at least 10 cross-sectional samples, and the average values of the hardnesses and the Young's moduli that were obtained from the respective samples were regarded as the hardness H and the Young's modulus E of the hard layer. Data that were considered as abnormal values at first glance were excluded. In addition, the ratios H/E of the hardness H to the Young's modulus E were also obtained. The results are shown in Table 3.

**[Table 3]**

| Specimen | Crystal structure of hard layer | | | Mechanical characteristics of hard layer | | |
|---|---|---|---|---|---|---|
| | Principal phase | I₍₂₀₀₎/I₍₀₀₂₎ | Peak full width at half maximum of I₍₀₀₂₎ | Hardness H (GPa) | Young's modulus E (GPa) | H/E |
| 1 | Cubic crystal + hexagonal crystal | 4.6 | 2.2 | 40.1 | 440.7 | 0.091 |
| 2 | Cubic crystal + hexagonal crystal | 6.3 | 3.1 | 38.1 | 453.6 | 0.084 |
| 3 | Cubic crystal + hexagonal crystal | 7.2 | 3.4 | 31.1 | 409.2 | 0.076 |
| 4 | Cubic crystal + hexagonal crystal | 5.6 | 2.7 | 32.2 | 407.6 | 0.079 |
| 5 | Cubic crystal + hexagonal crystal | 2.1 | 2.1 | 36.1 | 468.8 | 0.077 |
| 6 | Cubic crystal + hexagonal crvstal | 4.9 | 2.5 | 36.5 | 474.0 | 0.077 |
| 7 | Cubic crystal + hexagonal crystal | 5.5 | 2.6 | 33.5 | 458.9 | 0.073 |
| 8 | Cubic crystal + hexagonal crystal | 4.1 | 2.8 | 42.2 | 649.2 | 0.065 |
| 9 | Cubic crystal + hexagonal crystal | 3.1 | 2.2 | 32.4 | 490.9 | 0.066 |
| 10 | Cubic crystal + hexagonal crystal | 8.2 | 3.9 | 30.7 | 451.5 | 0.068 |
| 11 | Cubic crystal + hexagonal crystal | 5.2 | 2.9 | 29.1 | 440.9 | 0.066 |
| 12 | Cubic crystal + hexagonal crystal | 9.5 | 5.1 | 29.3 | 542.6 | 0.054 |
| 101 | Hexagonal crystal | - | - | 27.2 | 445.9 | 0.061 |
| 102 | Cubic crystal + hexagonal crystal | 9.7 | 2.2 | 31.2 | 528.8 | 0.059 |
| 103 | Cubic crystal | - | - | 30.1 | 501.7 | 0.060 |
| 104 | Hexagonal crystal | - | - | 30.2 | 616.3 | 0.049 |
| 105 | Cubic crystal | - | - | 28.7 | 494.8 | 0.058 |
| 106 | Cubic crystal + hexagonal crystal | 2.3 | 4.9 | 25.1 | 398.4 | 0.063 |
| 107 | Hexagonal crystal | - | - | 27.3 | 395.7 | 0.069 |

### <<Cutting Test>>

### <Cutting Evaluation (1)>

A cutting process was performed using the obtained cutting tool (blade edge-replaceable cutting tip P for cutting by rolling) under cutting conditions described below, and the cutting distance was measured until the amount of a flank face of a blade edge worn became 0.2 mm. The results are shown in Table 4. Table 4 shows that the wear resistance becomes superior as the cutting distance increases.
(Cutting Conditions)
Work material: SCM435 (block)
Cutting speed: 250 m/min.
Amount to be fed: 0.2 mm/t
Notch (axial direction): 2 mm
Notch (radial direction): 100% of tool diameter
Dry type

### <<Cutting Test>>

### <Cutting Evaluation (2)>

A cutting process was performed using the obtained cutting tool (blade edge-replaceable cutting tip K for cutting by rolling) under cutting conditions described below, and the cutting distance was measured until the amount of a flank face of a blade edge worn became 0.3 mm. The results are shown in Table 4. Table 4 shows that the wear resistance becomes superior as the cutting distance increases.

### (Cutting Conditions)

Work material: INCONEL 625 (shape: block)
Cutting speed: 60 m/min.
Amount to be fed: 0.15 mm/t
Notch (axial direction): 2 mm
Notch (radial direction): 70% of tool diameter
Wet type

**[Table 4]**

| Specimen | Cutting evaluation (1) | Cutting evaluation (2) |
|---|---|---|
| | Cutting distance (mm) | Cutting distance (mm) |
| 1 | 5000 | 3100 |
| 2 | 4900 | 2900 |
| 3 | 4600 | 2700 |
| 4 | 4800 | 2700 |
| 5 | 4500 | 2900 |
| 6 | 4100 | 2100 |
| 7 | 4400 | 2300 |
| 8 | 4400 | 2000 |
| 9 | 3500 | 1900 |
| 10 | 3800 | 1800 |
| 11 | 3800 | 1600 |
| 12 | 3500 | 1200 |
| 101 | 1500 | 500 |
| 102 | 1800 | 400 |
| 103 | 1900 | 600 |
| 104 | 800 | 300 |
| 105 | 1300 | 400 |
| 106 | 2500 | 600 |
| 107 | 1200 | 500 |

### <Results>

The results of the cutting evaluation (1) show that, for the cutting tools of Specimens 1 to 12, the cutting distances were 3500 mm or more and favorable results were obtained. On the other hand, for the cutting tools of Specimens 101 to 107, the cutting distances were 2500 mm or less. From the above-described results, it was found that the cutting tools of Specimens 1 to 12 according to the Examples were excellent in terms of wear resistance (Table 4).

The results of the cutting evaluation (2) show that, for the cutting tools of Specimens 1 to 12, the cutting distances were 1200 mm or more and favorable results were obtained. On the other hand, for the cutting tools of Specimens 101 to 107, the cutting distances were 600 mm or less. From the above-described results, it was found that the cutting tools of Specimens 1 to 12 according to the Examples were excellent in terms of wear resistance (Table 4).

The embodiment and the Examples of the present invention have been described as above, while an appropriate combination of the configuration of each embodiment and each Example described above is also assumed.

The embodiment and the Examples disclosed this time shall be considered to be exemplary in all aspects and do not limit anything. The scope of the present invention is shown by the claims.

### REFERENCE SIGNS LIST

1 Rake face, 2 Flank face, 3 Blade edge ridge portion, 10 Cutting tool, 11 Base material, 20 Hard layer, 23 Cubic columnar crystal, 24 Hexagonal columnar crystal, 31 Underlayer, 32 Surface layer, 40 Coating

## Claims

1. A cutting tool (10) comprising a base material (11) and a hard layer (20)
provided on the base material (11),
wherein the hard layer (20) is composed of a compound represented by TiₐAl_{b}B_{c}N,
an atomic ratio a of a titanium element in the TiₐAl_{b}B_{c}N is 0.25 or more and less than 0.55,
an atomic ratio b of an aluminum element in the TiₐAl_{b}B_{c}N is 0.45 or more and less than 0.75,
an atomic ratio c of a boron element in the TiₐAl_{b}B_{c}N is 0.01 or more and 0.09 or less,
a sum of the atomic ratio a, the atomic ratio b and the atomic ratio c is 1, and
a full width at half maximum of the X-ray diffraction peak of the (002) plane is 2 degrees or more and 8 degrees or less,
**characterized in that** a ratio I₍₂₀₀₎/I₍₀₀₂₎ of an intensity I₍₂₀₀₎ of an X-ray diffraction peak of a (200) plane to an intensity I₍₀₀₂₎ of an X-ray diffraction peak of a (002) plane in the hard layer (20) is 2 or more and 10 or less, the intensity I₍₂₀₀₎ of an X-ray diffraction peak of a (200) plane being the diffraction intensity of the highest peak of X-ray diffraction peaks derived from the (200) plane and being derived from cubic crystals in the hard layer (20), the intensity I₍₀₀₂₎ of an X-ray diffraction peak of a (002) plane being the diffraction intensity of the highest peak of X-ray diffraction peaks derived from the (002) plane and being derived from hexagonal crystals in the hard layer (20), the X-ray diffraction being carried out using the method described in the description.

2. The cutting tool (10) according to claim 1,
wherein the hard layer (20) has hardness H of 30 Gpa or more at room temperature.

3. The cutting tool (10) according to claim 2,
wherein a ratio H/E of the hardness H of the hard layer (20) to Young's modulus E of the hard layer (20) at room temperature is 0.07 or more.

4. The cutting tool (10) according to any one of claims 1 to 3,
wherein the hard layer (20) has a thickness of 1 µm or more and 20 µm or less.

## Patentansprüche

1. Schneidwerkzeug (10), das ein Basismaterial (11) und eine auf dem Basismaterial (11) vorgesehene harte Schicht (20) umfasst,
wobei die harte Schicht (20) aus einer Verbindung besteht, die durch TiₐAl_{b}B_{c}N wiedergegeben wird,
wobei das Atomverhältnis a eines Titanelements in dem TiₐAl_{b}B_{c}N 0,25 oder mehr und weniger als 0,55 beträgt,
wobei das Atomverhältnis b eines Aluminiumelements in dem TiₐAl_{b}B_{c}N 0,45 oder mehr und weniger als 0,75 beträgt,
wobei das Atomverhältnis c eines Borelements in dem TiₐAl_{b}B_{c}N 0,01 oder mehr und 0,09 oder weniger beträgt,
wobei die Summe aus dem Atomverhältnis a, dem Atomverhältnis b und dem Atomverhältnis c 1 ist und
wobei die volle Breite beim halben Maximum der Röntgenbeugungsspitze der (002)-Ebene 2 Grad oder mehr und 8 Grad oder weniger beträgt,
**dadurch gekennzeichnet, dass** das Verhältnis I₍₂₀₀₎/I₍₀₀₂₎ einer Intensität I₍₂₀₀₎ einer Röntgenbeugungsspitze einer (200)-Ebene zu einer Intensität I₍₀₀₂₎ einer Röntgenbeugungsspitze einer (002)-Ebene in der harten Schicht (20) 2 oder mehr und 10 oder weniger beträgt, wobei die Intensität I₍₂₀₀₎ einer Röntgenbeugungsspitze einer (200)-Ebene die Beugungsintensität der höchsten Spitze der von der (200)-Ebene abgeleiteten und von kubischen Kristallen in der harten Schicht (20) abgeleiteten Röntgenbeugungsspitzen ist, wobei die Intensität I₍₀₀₂₎ einer Röntgenbeugungsspitze einer (002)-Ebene die Beugungsintensität der höchsten Spitze der von der (002)-Ebene abgeleiteten und von hexagonalen Kristallen in der harten Schicht (20) abgeleiteten Röntgenspitzen ist und wobei die Röntgenbeugung unter Verwendung der in der Beschreibung beschriebenen Methode durchgeführt wird.

2. Schneidwerkzeug (10) nach Anspruch 1,
wobei die harte Schicht (20) eine Härte H von 30 Gpa oder mehr bei Raumtemperatur aufweist.

3. Schneidwerkzeug (10) nach Anspruch 2,
wobei das Verhältnis H/E der Härte H der harten Schicht (20) zu dem Young-Modul E der harten Schicht (20) bei Raumtemperatur 0,07 oder mehr beträgt.

4. Schneidwerkzeug (10) nach einem der Ansprüche 1 bis 3,
wobei die harte Schicht (20) eine Dicke von 1 µm oder mehr und 20 µm oder weniger aufweist.

## Revendications

1. Outil de coupe (10) comprenant un matériau de base (11) et une couche dure (20) disposée sur le matériau de base (11), dans lequel
la couche dure (20) est composée d'un composé représenté par TiₐAl_{b}B_{c}N,
le rapport atomique a du titane élémentaire dans le TiₐAl_{b}B_{c}N est de 0,25 ou plus et inférieur à 0,55,
le rapport atomique b de l'aluminium élémentaire dans le TiₐAl_{b}B_{c}N est de 0,45 ou plus et inférieur à 0,75,
le rapport atomique c du bore élémentaire dans le TiₐAl_{b}B_{c}N est de 0,01 ou plus et 0,09 ou moins,
la somme du rapport atomique a, du rapport atomique b et du rapport atomique c est de 1, et
la largeur à mi-hauteur du pic de diffraction des rayons X du plan (002) est de 2 degrés ou plus et 8 degrés ou moins,
**caractérisé en ce que** le rapport I₍₂₀₀₎/I₍₀₀₂₎ de l'intensité I₍₂₀₀₎ d'un pic de diffraction des rayons X d'un plan (200) à l'intensité I₍₀₀₂₎ d'un pic de diffraction des rayons X d'un plan (002) dans la phase dure (20) est de 2 ou plus et 10 ou moins, l'intensité I₍₂₀₀₎ d'un pic de diffraction des rayons X d'un plan (200) étant l'intensité de diffraction du pic le plus haut parmi les pics de diffraction des rayons X dérivés du plan (200) et dérivant de cristaux cubiques dans la couche dure (20), l'intensité I₍₀₀₂₎ d'un pic de diffraction des rayons X d'un plan (002) étant l'intensité de diffraction du pic le plus haut parmi les pics de diffraction des rayons X dérivés du plan (002) et dérivant de cristaux hexagonaux dans la couche dure (20), la diffraction des rayons X étant réalisée par utilisation du procédé décrit dans la description.

2. Outil de coupe (10) selon la revendication 1, dans lequel la couche dure (20) a une dureté H de 30 GPa ou plus à la température ambiante.

3. Outil de coupe (10) selon la revendication 2, dans lequel le rapport H/E de la dureté H de la couche dure (20) au module de Young E de la couche dure (20) à la température ambiante est de 0,07 ou plus.

4. Outil de coupe (10) selon l'une quelconque des revendications 1 à 3, dans lequel la couche dure (20) a une épaisseur de 1 µm ou plus et 20 µm ou moins.
